# DEMANDE DE BREVET EUROPEEN

(11) **EP 4 790 332 A1**
(43) Date de publication de la demande: **12.08.2026**
(21) Numéro de dépôt: 26156384.5
(22) Date de dépôt: 04.02.2026
(51) Int. Cl.: F25B 23/00, F28D 15/04, F25B 49/02

(54) **BOUCLE DIPHASIQUE DE TRANSFERT THERMIQUE A POMPAGE REDONDANT**

(30) Priorité: 06.02.2025 FR 2501212
(71) Demandeur: Calyos SA, 6040 Jumet (BE)
(72) Inventeur: DUPONT, Vincent, 1160 Auderghem (BE)
(74) Mandataire: Bandpay & Greuter

(57) **Abrégé**

Système de transfert thermique (100) comprenant un circuit principal (10) en boucle fermée, comprenant une quantité prédéfinie de fluide réfrigérant, un échangeur refroidisseur (5) couplé à une source froide, pour évacuer des calories et sous refroidir le fluide, une pompe (1) sur une branche parallèle (14) au circuit principal, pour impartir une circulation de liquide dans le circuit principal selon la direction de circulation (F), un boitier intermédiaire (3) placé en série sur le circuit principal, présentant 3 ou 4 ports, avec une entrée et une sortie de liquide et une entrée vapeur, un ensemble évaporateur (2) agencé en dérivation du circuit principal avec une canalisation d'admission (21), un évaporateur (20) incluant un élément poreux (22) à pompage capillaire couplé à une source chaude à refroidir, au moins une canalisation de sortie (25) avec une buse d'éjection (26) qui injecte le fluide en phase principalement vapeur dans le boitier intermédiaire.

## Description

L'invention concerne les systèmes de transfert thermique et plus particulièrement les boucles diphasiques de refroidissement. Ce type de systèmes est utilisé pour refroidir divers appareils et en particulier pour refroidir un ou plusieurs processeurs d'une carte électronique.

Il est connu dans l'art d'utiliser avantageusement la circulation d'un fluide diphasique (aussi appelé 'fluide réfrigérant' dans le métier) avec un évaporateur et un condenseur, des changements de phase permettant de transporter efficacement la chaleur d'un point à un autre. Il est connu d'utiliser ce genre de système pour refroidir des cartes électroniques, notamment des cartes serveurs de 'data center'.

Mais les systèmes en question sont aussi destinés à être utilisés dans des systèmes embarqués, par exemple dans des systèmes embarqués automobiles, ferroviaires ou aéronautiques.

On note que les systèmes de transfert thermique proposés ici peuvent aussi être utilisés comme systèmes de réchauffement antigivrage dans un aéronef (pour éviter le givre au bord d'attaque de voilure et/ou en entrée air réacteur) ou pour d'autres applications de transfert de chaleur.

D'une première manière connue, la circulation du fluide de travail dans la boucle peut être générée par une pompe mécanique. D'une deuxième manière également connue, la circulation du fluide de travail dans la boucle peut être obtenue par un effet de thermosiphon, utilisant la gravité terrestre. Enfin, d'une troisième manière également connue, la circulation du fluide de travail dans la boucle peut être obtenue par un effet de pompage capillaire assurée une mèche poreuse, solution particulièrement pertinente pour les applications spatiales et/ou en microgravité.

On note une excellente efficacité de la solution à pompe en fonctionnement nominal, mais cependant concernant la solution impliquant une pompe mécanique, il peut arriver que la pompe en question subisse une avarie et/ou tombe en panne. La survenance d'une panne de pompe implique l'arrêt de la circulation du fluide et par conséquent une interruption de la fonction refroidissement.

Les deuxième et troisième solutions reposent sur un principe de fonctionnement passif, sans nécessité de pompage actif i.e. sans éléments matériels mobiles.

Mais concernant la solution impliquant un effet de thermosiphon, l'efficacité de la solution dépend de l'orientation des portions respectives du circuit de fluide et des positions respectives de l'évaporateur et du condenseur.

Et concernant la solution impliquant un effet de pompage capillaire, la performance dépend de l'équilibre entre pertes de charges dans le circuit et pression d'aspiration capillaire.

Ainsi, il s'avère que chacune des solutions ci-dessus a des avantages et des inconvénients propres.

Les inventeurs ont cherché à proposer une solution de système de transfert thermique qui allient les avantages des solutions ci-dessus et qui minimisent leurs inconvénients. Il est aussi souhaitable que la solution proposée puisse refroidir simultanément plusieurs appareils et/ou plusieurs processeurs en limitant les instabilités thermo-hydrauliques.

A cet effet, il est proposé un système de transfert thermique comprenant :
- un circuit principal en boucle fermée, comprenant une quantité prédéfinie de fluide réfrigérant (diphasique), avec une direction de circulation de boucle de fluide,
- au moins un échangeur refroidisseur, comprenant une portion du circuit principal et un échangeur de chaleur couplé à une source froide, pour évacuer des calories et sous refroidir le liquide, pour délivrer du liquide sous-refroidi,
- au moins une pompe agencée sur une branche parallèle au circuit principal, pour impartir une circulation de liquide dans le circuit principal selon la direction de circulation de boucle, avec prélèvement et rejet à des endroits respectifs où le réfrigérant est en phase liquide,
- au moins un boitier intermédiaire placé en série sur le circuit principal, présentant au moins 3 ports, à savoir une entrée de liquide, une sortie de liquide, et une entrée vapeur, l'entrée de liquide recevant le liquide sous-refroidi en provenance de l'échangeur refroidisseur,
- au moins un ensemble évaporateur agencé en dérivation du circuit principal avec
- au moins une canalisation d'admission, prélevant du fluide liquide sur le circuit principal,
- un évaporateur incluant un élément poreux à pompage capillaire couplé à une source chaude à refroidir, pour être le siège d'une vaporisation du fluide réfrigérant,
- au moins une canalisation de sortie ayant au moins une buse d'éjection qui injecte le fluide en phase principalement vapeur dans le boitier intermédiaire via l'entrée vapeur selon la direction de circulation de boucle.

Grâce à ces dispositions, la circulation du fluide est impartie par la pompe en fonctionnement normal, mais s'il advient une panne de pompe, alors l'injection de la vapeur depuis la canalisation de sortie de l'ensemble évaporateur dans le circuit principal provoque un effet d'entrainement par transfert de quantité de mouvement. Le jet de vapeur forme un effet moteur pour le circuit principal en boucle (« jet pump » en anglais) et on obtient une circulation forcée du fluide de travail dans la boucle principale, malgré le fait que la pompe mécanique ne tourne plus.

On remarque que la pompe étant agencée sur une branche parallèle, même si sa turbine (ou plus généralement son élément mobile) est bloquée, cela n'empêche pas la circulation du fluide dans la boucle principale. Même si la performance est diminuée par l'arrêt de la pompe, il reste une circulation substantielle de fluide dans la boucle principale générée par la ou les buse(s) d'éjection de vapeur. Par conséquent, une panne de la pompe n'empêche pas le fonctionnement de la boucle de continuer. Lorsque le système est installé à bord d'un véhicule, la survenance d'une panne de la pompe, peut conduire à une diminution de performance, mais n'entraine pas une perte totale de la fonction refroidissement.

Par contraste, si la pompe était agencée en série sur le circuit principal, une panne de pompe conduirait à un arrêt total de la circulation et à une interruption totale du service de refroidissement.

La solution proposée tire ainsi avantageusement parti d'une part de la performance thermique apportée par la circulation forcée de la pompe en combinaison d'autre part avec une circulation passive induite par les buses de sortie des évaporateurs dans le ou les boitiers intermédiaires.

Par ailleurs, selon les configurations possibles, la circulation dans la boucle peut être favorisée par un effet de thermosiphon, ou à l'inverse, la circulation peut être dépourvue d'aide par un effet de thermosiphon.

On remarque que le débit de la pompe peut rester modéré puisque seule une portion du débit total est dérivée du circuit principal et par conséquent la consommation électrique du moteur de pompe peut rester minime. Le débit de la pompe peut être choisi dans un intervalle optimal compris entre une valeur minimum et une valeur maximum, ce qui sera discuté plus loin.

Le fluide est essentiellement liquide dans le circuit principal en boucle et l'échangeur refroidisseur est un échangeur de sous refroidissement ; ce qui a pour avantage de minimiser les pertes de charge vapeur de circulation des fluides basses pressions dans le circuit principal en boucle ; la condensation de la vapeur qui sort de l'éjecteur se produit dans le boitier intermédiaire, e.g. dans la portion du circuit principal immédiatement adjacente, en aval au point d'injection de vapeur. L'échangeur de sous refroidissement assure un sous refroidissement suffisant pour que la phase liquide dans le circuit principal reste liquide même en présence de fuites thermiques parasites et évite la cavitation dans la pompe. L'avantage d'avoir essentiellement du liquide dans le circuit principal est que le fonctionnement du système est très peu impacté par des accélérations subies, par exemple dans un véhicule avec des directions changeantes et une intensité éminemment variable et qu'il permet d'utiliser des fluides basses pressions sans occasionner des pertes de charges rédhibitoires.

Un autre avantage d'avoir essentiellement du liquide dans le circuit principal est que la répartition du fluide liquide à l'intérieur d'une forme complexe et fortement tridimensionnelle est plus simple qu'en phase vapeur ou diphasique où la répartition serait impactée par les inclinaisons et accélération (de la pesanteur ou du véhicule).

La notion de sous refroidissement désigne un refroidissement en dessous de la température de saturation Tsat (température d'équilibre liquide-vapeur pour la pression qui prévaut dans le circuit). En pratique, le liquide sous-refroidi qui sort de l'échangeur refroidisseur se trouve à une température plus basse de 5°C à 10°C par rapport à la température de saturation Tsat.

Dans des modes de réalisation du dispositif selon l'invention, on peut éventuellement avoir recours en outre à l'une et/ou à l'autre des dispositions suivantes.

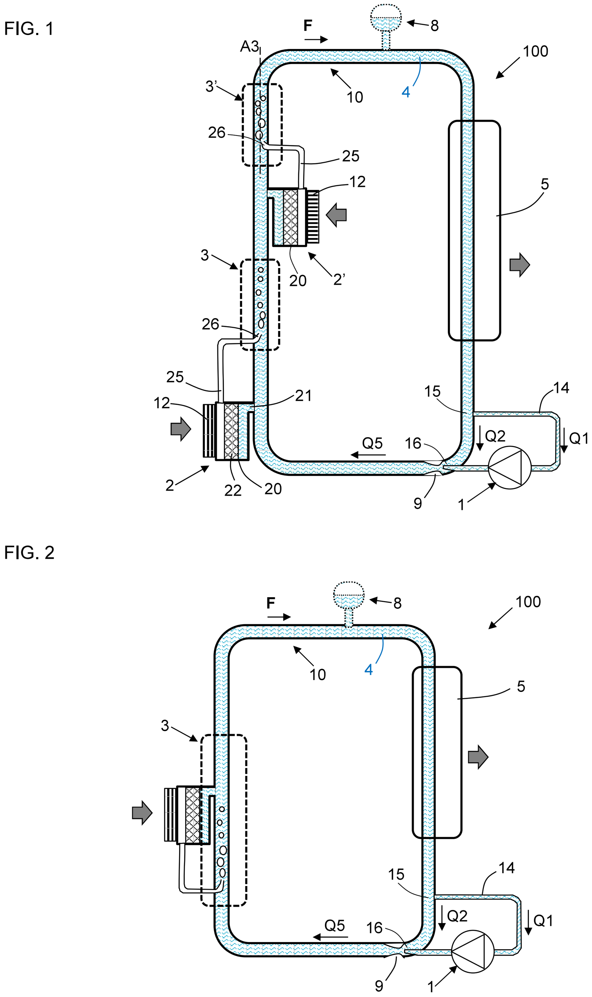

Selon une réalisation, la pompe est alimentée par du liquide sous-refroidi en provenance de l'échangeur refroidisseur et rejette plus en aval un jet de liquide dans le circuit principal, en amont du boitier intermédiaire. Cette configuration est illustrée aux figures 1 à 3.

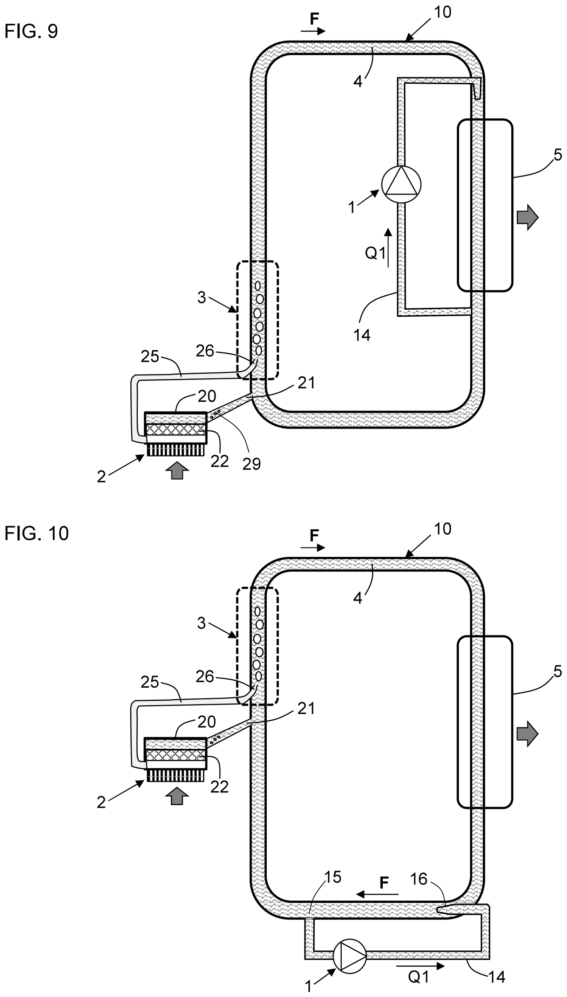

Selon une réalisation alternative, la pompe est alimentée par du liquide prélevé en amont de l'échangeur refroidisseur, et rejette du liquide en aval de l'échangeur refroidisseur. Cette configuration est illustrée à la figure 9.

Selon une réalisation alternative, la pompe est alimentée par du liquide prélevé en un point intermédiaire entre l'échangeur refroidisseur et le boîtier intermédiaire, et rejette du liquide en amont dudit point intermédiaire. De façon remarquable, le rejet se trouve en amont du prélèvement. Cette configuration est illustrée à la figure 10.

Selon une réalisation, le boitier intermédiaire comprend un volume intérieur disponible pour loger un excédent de liquide, faisant fonction de réservoir et de vase d'expansion.

Avantageusement, la fonction réservoir étant alors logée à l'intérieur d'au moins un boîtier intermédiaire, il n'est pas nécessaire dans ce cas de prévoir un réservoir spécifique à un endroit sur le circuit principal de boucle.

Selon une réalisation, le boitier intermédiaire présente une forme allongée avec un axe selon la direction locale de circulation de boucle.

On note que l'axe A3 du boitier intermédiaire peut être parallèle à la verticale locale ce qui favorise l'effet de thermosiphon et la remontée d'éventuelles bulles de vapeur vers le haut depuis l'entrée liquide du ou des évaporateurs capillaires, en plus de l'effet d'entraînement par quantité de mouvement.

Selon d'autres configurations, l'axe A3 du boîtier intermédiaire peut être incliné par rapport à la verticale. Il peut être même à l'horizontale.

Selon une réalisation, le boitier intermédiaire présente une forme généralement cylindrique. Le boîtier intermédiaire est dans ce cas facile à fabriquer et présente une bonne résistance à la pression sans masse excessive. Cette configuration présente un bon rapport prestation sur coût et permet réaliser des joints étanches de façon bien maîtrisée.

Selon une réalisation, le boitier intermédiaire comprend un tube de guidage qui entoure la buse d'éjection. Le tube de guidage permet de maximiser la condensation de vapeur locale à la sortie de la buse d'éjection. Le tube de guidage peut être appelé « tube de confinement » ou « tube de passage contraint ».

Selon une réalisation, il peut être prévu un ou plusieurs tubes intérieurs dans le boitier intermédiaire, les tubes s'étendant le long de l'axe de la buse. Chaque tube peut être agencé en face d'une buse d'éjection de vapeur.

Selon une réalisation, le changement d'état de la phase vapeur vers la phase liquide se produit essentiellement dans le boitier intermédiaire.

Comme le liquide circulant dans la boucle principale est sous-refroidi, il permet de condenser les bulles de vapeur à la volée à l'intérieur du boîtier intermédiaire ; on parle alors de condensation directe. Le boîtier intermédiaire peut ainsi être qualifié de boîtier à condensation directe. En fonctionnement nominal, la sortie liquide du boîtier intermédiaire ne contient en pratique pas de bulles de fluide réfrigérant sous forme vapeur.

Selon une réalisation, le système peut comprendre une source à refroidir en contact thermique conductif avec une portion de canalisation du circuit principal.

Moyennant quoi, il se produit à cet endroit une condensation directe du côté intérieur de la paroi, en raison de la température du fluide sous refroidi plus basse que Tsat.

Il s'agit d'une autre solution pour refroidir une source à refroidir, qui s'avère de bonne compacité. Grâce à cela, on a ainsi une variété de solutions et une variété des points de collecte de calories.

Selon une réalisation, le boitier intermédiaire comprend une deuxième sortie liquide raccordée à la canalisation d'admission de l'ensemble évaporateur.

Dans ce cas, il n'y a pas de piquage spécifique réalisé sur la conduite principale ; le piquage d'alimentation en liquide de l'ensemble évaporateur est réalisé dans le boîtier intermédiaire, de préférence en partie basse et/ou proche de l'entrée de liquide.

On obtient ainsi une optimisation des piquages et des endroits où il faut réaliser un joint étanche ou une soudure étanche.

Selon une réalisation, le boitier intermédiaire comprend une séparation interne délimitant une chambre de distribution en amont du tube de guidage.

Selon une réalisation, il peut être prévu plusieurs buses d'éjection de vapeur en provenance d'un ou plusieurs évaporateur(s). Ceci confère au dispositif une très bonne compacité. Un même boîtier intermédiaire peut recevoir plusieurs buses d'éjection.

Selon une réalisation, la buse d'éjection est placée en aval de la canalisation d'admission de l'évaporateur. Moyennant quoi, l'admission de liquide se fait à une température plus basse que la température moyenne à l'endroit de la condensation des bulles plus en aval.

Ceci s'avère plus efficient vis-à-vis de la fonction d'évacuation des bulles dans certaines configurations de flux.

Selon une réalisation alternative, la buse d'éjection peut être placée en amont de la canalisation d'admission de l'évaporateur.

Cela n'empêche pas un fonctionnement correct et cela permet de répondre à un certain besoin d'intégration ou de configuration spatiale de l'équipement à refroidir.

Selon une réalisation, l'échangeur refroidisseur est placé plus haut que le boitier intermédiaire. Le système peut ainsi bénéficier d'un effet de thermosiphon dû à la gravité.

Selon une réalisation alternative, l'échangeur refroidisseur est placé plus bas que le boitier intermédiaire. Le pompage capillaire assisté par la pompe permet tout de même un fonctionnement correct souhaité sans effet de thermosiphon.

Selon une réalisation, le réservoir est réparti le long des tubes, à l'extérieur des tubes. Le réservoir est ainsi distribué, sans nécessité de prévoir un réservoir spécifique.

Selon une réalisation, il peut être prévu un ou plusieurs autre(s) boitier(s) intermédiaire(s) en aval du premier boîtier intermédiaire, chaque autre boîtier intermédiaire étant agencé en série sur le circuit principal de boucle.

On peut ainsi refroidir plusieurs équipements électroniques situés à des endroits différents sur le parcours de la boucle principale. Chaque boîtier intermédiaire comprend au moins une buse d'éjection de vapeur ce qui contribue à la circulation du liquide dans la boucle principale même si la pompe venait à s'arrêter.

Selon une réalisation, il peut être prévu plusieurs ensembles évaporateurs (2,2') agencés en dérivation du circuit principal sensiblement au même endroit sur le circuit principal de boucle. Ceci peut convenir pour des configurations où les sources chaudes sont proches les unes des autres. Le système ainsi formé est particulièrement compact.

Selon une réalisation, le régime de rotation de la pompe est piloté entre un seuil de rotation mini et un seuil de rotation maxi (régime de rotation ou équivalent).

Les inventeurs ont pu constater qu'un régime de rotation trop important et donc un flux de liquide froid trop intense dans la boucle principale n'amenait pas d'avantages, voire augmentait le risque de désamorçage d'un des évaporateurs du fait de la saturation totale du réservoir avec le liquide sous-refroidi pour des configurations à réservoir volumineux. Selon un exemple, on choisit un régime de pompe donnant un débit horaire de 5 à 15 litres par minute.

Selon une réalisation, il est prévu dans le circuit principal une restriction de section juste en aval du rejet de la pompe. Ceci est favorable à l'efficacité du pompage, on peut avoir un facteur multiplicateur par rapport au débit général dans la boucle principale. En pratique, on constate que le débit qui passe par la pompe dans la branche parallèle et qui sort au niveau de la restriction de section induit un débit 3 à 4 fois plus important dans le circuit principal.

La restriction de section permet aussi d'éviter un rebouclage local qui refermerait localement la branche parallèle où la pompe se trouve.

Selon une réalisation, la pompe est une pompe centrifuge présentant un poids inférieur à 1 kg et la pompe est inscrite dans un volume cubique d'au plus 100 mm de côté.

On propose une solution compacte et légère, tout à fait compatible avec un système embarqué dans un véhicule, y compris dans un véhicule aéronautique où le poids et le volume occupé sont particulièrement critiques.

Selon une réalisation, le (ou les) évaporateur(s) est (sont) positionné(s) en contrebas du circuit principal. Moyennant quoi, comme la canalisation de l'admission de l'évaporateur est descendante, s'il advient qu'il se trouve des bulles de vapeur ou de gaz non condensable à cet endroit, elles vont être évacuées en remontant naturellement et en rejoignant le circuit principal et le réservoir vase d'expansion.

Selon une réalisation, le fluide de travail est de l'acétone. Ce fluide présente des caractéristiques intrinsèques particulièrement pertinentes pour une application diphasique à haute exigence de fiabilité.

Selon une autre réalisation, le fluide de travail peut être chois parmi : l'isooctane, le fluide R133zd-E, le fluide R136mzz-Z, l'éthanol, le cyclopentane, un fluide à base de butène ou butane, un fluide à base de pentène, un fluide à base de butadiène, un fluide à base de toluène.

Selon une réalisation, la pression dans le circuit de fluide est comprise entre 2 bars et 5 bars.

Selon une réalisation, il prévu un premier ratio entre le débit massique de liquide dans la boucle principale et le débit massique de vapeur sortant des buses d'éjection des évaporateurs, et ledit premier ratio est généralement compris entre 3.5 et 50.

Selon une réalisation, le système est soumis à la gravité terrestre, et le circuit principal en boucle s'étend dans un plan sensiblement horizontal par rapport à la gravité. Le fluide peut circuler dans la boucle principale sans utiliser d'effet de thermosiphon, l'effet moteur dans le circuit principal étant obtenu par des injections de vapeur en provenance d'évaporateur(s) et la pompe lorsqu'elle fonctionne.

Selon une réalisation, il peut être prévu un réservoir commun branché sur la boucle principale. On peut ainsi contrôler de façon centralisée les conditions opérationnelles de la boucle en maîtrisant la température de saturation Tsat, et cela fournit par ailleurs un rôle de vase d'expansion et d'accueil du liquide provenant des zones vapeur des évaporateurs capillaires, on peut ainsi éviter de prévoir une fonction réservoir dans chaque boitier intermédiaire.

Selon une réalisation, l'échangeur refroidisseur comprend une pluralité de sous-canaux arrangés en parallèle. On obtient une bonne efficacité de l'échange thermique à l'intérieur de l'échangeur refroidisseur.

D'autres aspects, buts et avantages de l'invention apparaîtront à la lecture de la description suivante d'un mode de réalisation de l'invention, donné à titre d'exemple non limitatif. L'invention sera également mieux comprise en regard des dessins joints sur lesquels *:*
- la figure 1 est un schéma de principe du système selon un premier mode de réalisation de l'invention, avec deux ensembles évaporateur en série, chacun raccordé à un boitier intermédiaire, et un réservoir optionnel,
- la figure 2 est un schéma de principe du système selon un deuxième mode de réalisation de l'invention, concernant la configuration de l'ensemble évaporateur,
- la figure 3 est un schéma de principe d'une variante, avec deux ensembles évaporateur raccordés à un même boitier intermédiaire,
- la figure 4 illustre un exemple générique de réalisation d'un boîtier intermédiaire recevant un flux de vapeur de l'ensemble d'un évaporateur associé, dans une configuration au repos c'est-à-dire a l'arrêt depuis un temps significatif,
- la figure 5 est analogue à la figure 4 et montre la configuration du boîtier intermédiaire en cours de fonctionnement nominal,
- la figure 6 est analogue à la figure 4 et montre la configuration du boîtier intermédiaire aux conditions de charge et débit maximum,
- la figure 7 illustre un graphique concernant les performances de la pompe,
- la figure 8 illustre schématiquement le fonctionnement de la pompe à jet de liquide à l'endroit où la sortie rejoint le circuit principal,
- la figure 9 est analogue à la figure 2 et illustre une variante concernant la configuration du circuit parallèle équipé de la pompe et la position de l'évaporateur,
- la figure 10 est analogue à la figure 2 et illustre une autre variante concernant la configuration du circuit parallèle équipé de la pompe,
- la figure 11 illustre schématiquement une variante de boîtier intermédiaire avec 4 ports,
- la figure 12 illustre schématiquement une variante de boîtier intermédiaire présentant un axe à l'horizontale.

Sur les différentes figures, les mêmes références désignent des éléments identiques ou similaires.

La figure 1 montre un système de transfert thermique **100** utilisant un fluide de travail diphasique 4 destiné à prélever des calories d'une source chaude **12** et à les évacuer à distance de la source chaude. Plus précisément, le système de transfert thermique comprend un circuit principal 10 en boucle. Le système de transfert thermique contient dans un volume intérieur, isolé de manière étanche de l'environnement extérieur, une quantité donnée de fluide de travail **4.**

Dans la présente description, on entend par « circuit principal **10** en boucle » une conduite ou une canalisation qui se re-boucle sur elle-même formant ainsi un circuit fermé pour le fluide de travail 4, on parle donc de « conduite principale » par opposition aux autres canalisations utilisées pour raccorder les évaporateurs agencés en parallèle et par opposition à la branche parallèle où est agencé la pompe. Le circuit principal est aussi appelé « bus thermique » et/ou « collecteur thermique général ».

Il est entendu que le circuit principal ne contient généralement aucun élément d'obstruction qui puisse gêner la libre circulation du fluide de travail, laquelle circulation se produit dans une direction de circulation privilégiée représentée par le repère **F.**

Généralement, le fluide de travail est un réfrigérant qui peut se trouver en phase liquide ou vapeur au voisinage des températures qui prévalent dans le circuit en boucle.

Selon un exemple particulier, le fluide de travail 4 est de l'acétone.

Selon d'autres exemples, le fluide de travail peut être chois parmi : l'isooctane, le fluide R133zd-E, le fluide R136mzz-Z, l'éthanol, le cyclopentane, un fluide à base de butène ou butane, un fluide à base de pentène, un fluide à base de butadiène, un fluide à base de toluène.

Le circuit principal en boucle fermée comprend une quantité prédéfinie de fluide réfrigérant. Il est prévu un orifice de remplissage, non représenté aux figures, ainsi qu'optionnellement un orifice de purge. La pression dans le circuit de fluides est comprise entre 2 bars et 5 bars.

On utilise de préférence des fluides basse pression qui occasionnent de faibles débits sur le circuit principal 10.

### Echangeur refroidisseur

Le système de transfert thermique comprend un échangeur refroidisseur 5.

L'échangeur refroidisseur 5 évacue les calories transportées par la conduite principale à distance de(s) la source(s) chaude(s) 12. L'échangeur refroidisseur 5 est formé par une portion de la conduite principale elle-même et un échangeur de chaleur couplé à une source froide ; cet échangeur de chaleur n'est volontairement pas détaillé ici, il peut être de tout type connu dans l'art, par exemple un échangeur à air avec des ailettes, optionnellement avec une convection forcée avec un ventilateur, cela peut être aussi par exemple un échangeur à liquide par exemple un échangeur à flux croisés avec un autre liquide, par exemple de l'eau.

Dans un exemple typique de cartes serveur, on évacue grâce au circuit principal les calories formées au niveau des processeurs, à distance de la carte serveur, dans un circuit de circulation d'eau conventionnel.

Selon un autre exemple, l'échangeur refroidisseur 5 peut être utilisé pour réchauffer un élément externe en délivrant des calories à cet équipement externe. Par exemple, l'échangeur refroidisseur 5 peut être utilisé pour réchauffer un bord d'attaque d'aile dans un aéronef ou une entrée d'air d'un turbopropulseur.

Avantageusement, l'échangeur refroidisseur procède à un sous refroidissement du liquide, pour délivrer du liquide sous-refroidi. En pratique, le liquide sous-refroidi qui sort de l'échangeur refroidisseur se trouve à une température plus basse de 5°C à 10°C par rapport à la température de saturation Tsat, Tsat étant la température d'équilibre liquide-vapeur pour la pression qui prévaut dans le circuit.

Le sous refroidissement est suffisant pour que la phase liquide dans le circuit principal reste liquide même en présence de fuites thermiques parasites. Par ailleurs, cela évite une cavitation éventuelle d'une pompe qui sera discutée plus loin. L'avantage d'avoir essentiellement du liquide dans le circuit principal est que le fonctionnement du système est très peu impacté par des accélérations subies, par exemple dans un véhicule avec des directions changeantes et une intensité éminemment variable, comme dans un aéronef.

Optionnellement, l'échangeur refroidisseur peut comprendre une pluralité de sous-canaux arrangés en parallèle afin de maximiser les échanges thermiques.

### Ensemble(s) évaporateur

Le système de transfert thermique comprend un ou plusieurs ensemble(s) évaporateur 2.

Avantageusement, pour prélever des calories depuis la source chaude 12, on dispose un ensemble évaporateur 2 agencé en dérivation du circuit principal. L'ensemble évaporateur 2 étant placé dans une configuration parallèle du circuit principal, il n'introduit pas une perte de charge dans le circuit principal 10.

L'ensemble évaporateur 2 comprend une canalisation d'admission **21,** prélevant du fluide liquide sur la boucle principale, un évaporateur **20** incluant un élément poreux **22** formant pompage capillaire et couplé thermiquement à une source chaude à refroidir, et une canalisation de sortie 25.

La canalisation de sortie **25** débouche dans un organe appelé ici « boitier intermédiaire » et qui sera décrit dans les paragraphes qui suivent. La canalisation de sortie **25** comprend à son extrémité une buse d'éjection **26** qui injecte le fluide en phase principalement vapeur dans le boitier intermédiaire.

La structure et les fonctions de l'évaporateur ne sont pas détaillées ici, la personne du métier peut se référer par exemple au document FR3065279 pour y trouver divers enseignements relatifs à un exemple d'évaporateur visé ici.

Dans le cas de figure représentée à la figure 1, on trouve deux ensembles évaporateurs 2, l'un agencé à la suite de l'autre le long du circuit principal 10, donc dans une configuration « série ». Nous verrons plus loin qu'ils peuvent être dans une configuration « parallèle ». Plus généralement, toute combinaison hybride, série et parallèle, peut fonctionner aussi grâce à la présente invention.

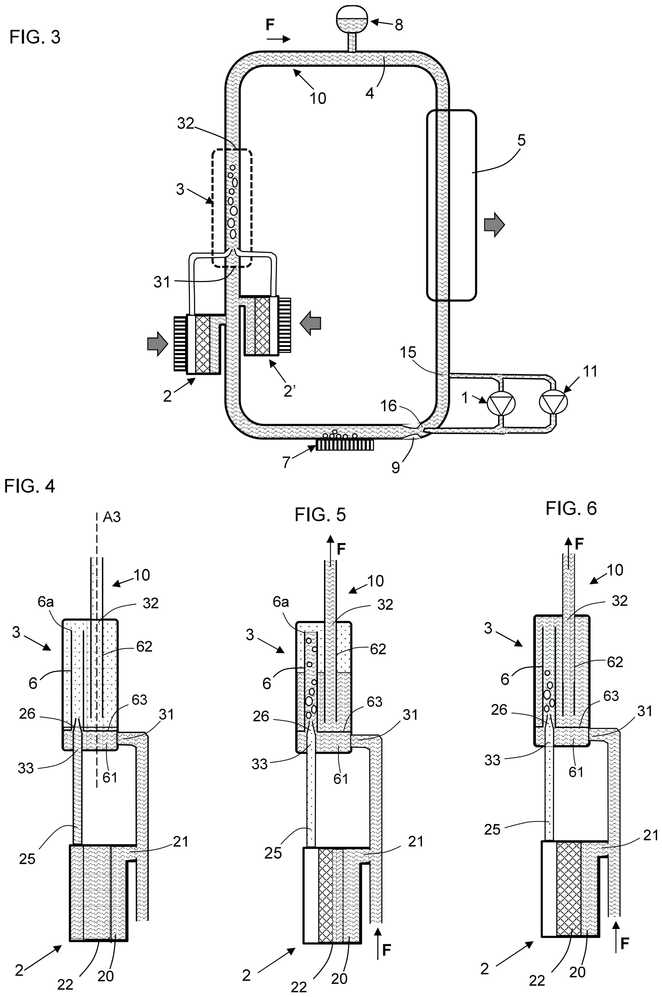

En complément des ensembles évaporateurs décrits ci-dessus, le système de transfert thermique peut aussi prélever des calories d'une façon alternative directement depuis une source à refroidir. Comme illustré à la figure 3, une source chaude à refroidir **7** se trouve en contact thermique conductif avec une portion de canalisation du circuit principal. À cet endroit, en fonction de la puissance thermique délivrée par la source chaude à refroidir il se produit une émulsion locale du côté intérieur de la paroi de la conduite. Du fait qu'on opère en régime sous refroidi, avec une température de boucle inférieure à Tsat, les bulles de vapeur créées à cet endroit sont condensées localement sans gêner l'arrivée de liquide vers la mèche poreuse.

Le système transfert thermique proposé peut ainsi combiner des systèmes d'évaporateur classique et des systèmes de prélèvement en contact conductif thermique direct.

### Boitier intermédiaire

Le système de transfert thermique comprend un ou plusieurs boitier intermédiaire **3** placé(s) en série sur le circuit principal. Chaque boitier intermédiaire 3 est associée à un ou plusieurs ensembles évaporateurs 2.

Comme visible à la figure 4, chaque boitier intermédiaire **3** présente au moins 3 ports, à savoir une entrée de liquide **31,** une sortie de liquide **32,** et une entrée vapeur **33,** l'entrée de liquide **31** recevant le liquide sous-refroidi en provenance de l'échangeur refroidisseur **5.**

Lorsqu'il y a un seul boîtier intermédiaire, comme illustré par exemple à la figure 3, le l'entrée de liquide **31** du boîtier intermédiaire reçoit le liquide sous refroidi en provenance de l'échangeur refroidisseur et délivre en aval du liquide via sa sortie de liquide 32 en direction de l'échangeur refroidisseur.

Lorsqu'il y a plusieurs boîtiers intermédiaires en série comme illustré à la figure 1, la sortie liquide **32** du premier boîtier intermédiaire **3** est dirigée vers l'entrée liquide **31** du deuxième boîtier intermédiaire **3'.**

Selon l'exemple présenté aux figures 4 à 6, le boitier intermédiaire **3** présente une forme allongée avec un axe **A3** selon la direction locale de circulation de boucle.

Selon l'exemple, le boitier intermédiaire présente une forme généralement cylindrique.

Selon un exemple, le diamètre extérieur du boîtier intermédiaire peut être compris entre 20 mm et 40 mm. Selon un exemple, le diamètre de la conduite principale peut être compris entre 8 mm et 20 mm. Les dimensions annoncées ne sont pas limitatives.

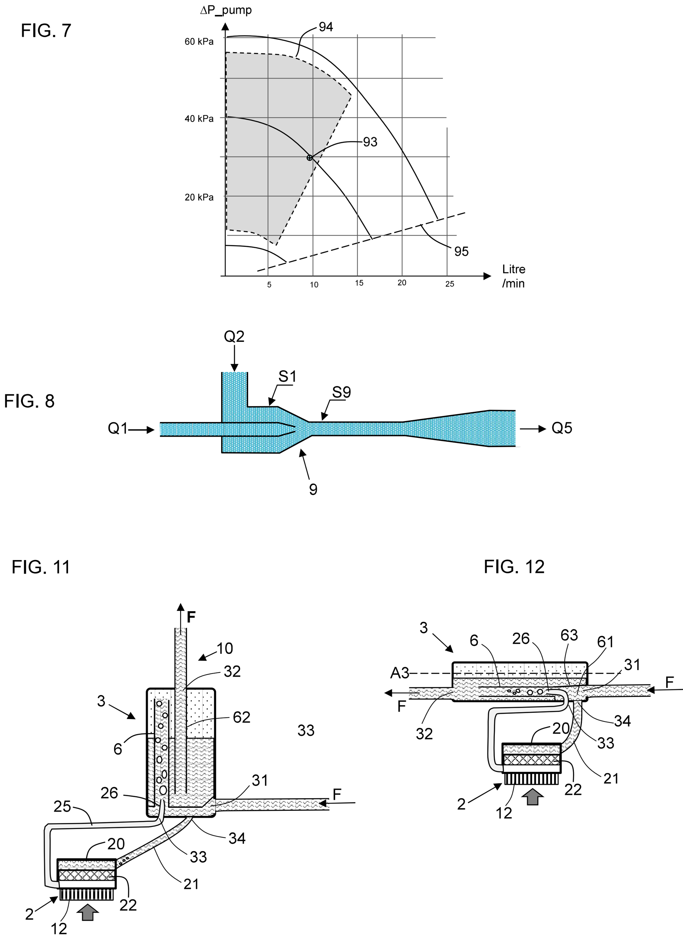

Selon une option représentée à la figure 11, le boitier intermédiaire 3 comprend une deuxième sortie liquide **34** raccordée à la canalisation d'admission **21** de l'ensemble évaporateur **2.**

La buse d'éjection **26** est placée en aval de la canalisation d'admission de l'évaporateur. Toutefois, selon une réalisation alternative représenté à la figure 2, la buse d'éjection peut être placée en amont de la canalisation d'admission de l'évaporateur (cf figure 2).

Le boitier intermédiaire 3 comprend un tube de guidage **6** qui entoure la buse d'éjection **26.** Le tube de guidage **6** permet de maximiser la condensation de vapeur locale à la sortie de la buse d'éjection. Comme illustré à la figure 5, le tube de guidage **6** comprend une extrémité ouverte **6a** à qui fait fonction de trop-plein c'est-à-dire que le liquide poussé par le jet de vapeur déborde pardessus le bord **6a.**

On remarque que le volume intérieur du tube de guidage **6** est le siège d'une condensation locale des bulles de vapeur qui sont éjectées par la buse d'éjection **26.**

Par ailleurs, il est prévu dans le boîtier intermédiaire un tube de sortie **62** qui canalise la sortie de liquide depuis le volume intérieur du boîtier intermédiaire 3 jusqu'au port de sortie **32.**

En option, il peut être prévu plusieurs tubes intérieurs de guidage **6** dans le boitier intermédiaire **3,** les tubes s'étendant le long de l'axe de la buse. Chaque tube est agencé en face d'une buse d'éjection 26 de vapeur. On a illustré un exemple à la figure 3 où il y a 2 buses de sortie **26** dans un boîtier intermédiaire **3** et par conséquent il y a deux tubes de guidage respectifs en vis-à-vis.

Le boitier intermédiaire **3** comprend une séparation interne **63** délimitant une chambre de distribution **61** en amont du tube de guidage **6.** Lorsque le boîtier intermédiaire **3** ne comporte qu'un tube de guidage **6** pour la condensation de vapeur, la chambre de distribution faire office de chambre tampon. Lorsque le boîtier intermédiaire 3 comporte plusieurs tubes de guidage 6 en parallèle, la chambre de distribution **61** fait office de plénum pour alimenter en liquide simultanément en parallèle les tubes de guidage 6 présents dans le boîtier intermédiaire.

On remarque que la conception présentée ici permet d'éviter que les bulles générées par la vaporisation de liquide (éjectées par buses de sortie **26)** ne sortent du boîtier intermédiaire **3.** Ainsi, les portions générales du circuit principal en boucle qui relient entre les boîtiers intermédiaires et l'échangeur refroidisseur restent exemptes de bulles et sont remplies uniquement de liquide, avec les avantages techniques exposés plus haut.

Dans l'exemple de variantes illustrée à la figure 12, l'axe **A3** du boîtier intermédiaire se trouve à l'horizontale, par opposition à la position verticale illustrée aux figures 4 à 6 et 11.

Dans ce cas de figure à l'horizontale, le boitier intermédiaire **3** peut être dépourvu de tube de sortie **62,** le port de sortie **32** étant naturellement alimenté en liquide sans risque d'avoir de la vapeur ou des bulles à cet endroit.

On remarque que la séparation interne **63** peut être aligné avec une partie du tube de guidage 6. Il faut aussi noter que le tube de guidage peut être formé par un déflecteur allongé qui coopère avec une paroi interne du boitier intermédiaire pour former ensemble un passage contraint similaire au tube de guidage exposé ci-avant.

Selon une option, il est prévu un réservoir spécifique **8** agencé dans une position de préférence élevée du circuit principal. Il peut être prévu sur ce réservoir une résistance de chauffage et un capteur de température afin de pouvoir piloter notamment la phase de démarrage du dispositif de transfert thermique.

Selon une autre solution, le réservoir formant vase d'expansion est formé dans chacun des boîtiers intermédiaires. On a représenté à la figure 6 un cas de figure ou du volume excédentaire se trouve à occuper l'ensemble du volume intérieur disponible dans le boîtier intermédiaire 3.

### Pompe

Le système de transfert thermique comprend une branche parallèle **14** au circuit principal avec une pompe **1.**

Il est prévu dans le circuit principal une restriction de section **9** juste en aval du rejet de la pompe.

Comme visible à la figure 8, la section **S9** en aval de la buse d'éjection du liquide est substantiellement plus petite que la section **S1** en amont. S'agissant des débits, on note **Q5** le débit général dans la boucle **Q1** le débit sortant de la branche parallèle avec la pompe. Le prélèvement de la branche de la pompe n'a pas été représenté à la figure 8, **Q5 = Q1 + Q2.** On peut choisir pour la section **S9** une valeur comprise entre 0,3 et 0,6 x **S1.** Q2 est le débit dans le circuit principal qui ne passe pas dans la branche 14 de la pompe.

Grâce à ces conditions géométriques, on peut obtenir un effet d'amplification de circulation à savoir **Q5** est de l'ordre de 3 à 4 fois **Q1.** La puissance nécessaire à faire tourner la pompe **1** s'avère ainsi particulièrement modéré.

Selon l'exemple illustré aux figures 1 à 2, la pompe 1est alimentée par du liquide sous-refroidi en provenance de l'échangeur refroidisseur **5** (point de prélèvement **15)** et rejette plus en aval un jet de liquide dans le circuit principal (point de rejet **16),** en amont du boitier intermédiaire **3.**

Selon un exemple préférentiel, la pompe **1** est une pompe centrifuge. Toutefois, d'autres types de pompes, comme des pompes à engrenage peuvent aussi être adoptées.

Selon une réalisation typique, la pompe **1** présente un poids inférieur à 1 kg. Selon une autre réalisation, le poids de la pompe peut être inférieur à 600 grammes.

Du point de vue volume occupé, selon un exemple, la pompe 1 est inscrite dans un volume cubique d'au plus 100 mm de côté, ce qui s'avère particulièrement compact. Selon un exemple préféré, le diamètre de la pompe peut être voisin de 80 mm.

La figure 7 illustre le dimensionnement d'une telle pompe en débit et pression. L'axe des abscisses porte le débit en litre par minute et l'axe des ordonnées montre la différence deltaP de pression entre la sortie et l'entrée en kiloPascals. La figure 7 illustre trois courbes d'iso vitesse de rotation, du minimum en bas jusqu'au maximum en haut.

La droite repérée **95** illustre la zone de risque de cavitation de la pompe. La zone grisée **94** illustre la région de fonctionnement idéal pour l'application. On choisit un point de fonctionnement cible **93** avec un débit de l'ordre de 10 litres par minute pour un deltaP de 30 kPa. Dès que le système de transfert thermique est en service, la pompe est pilotée à vitesse constante correspondant au point de fonctionnement **93.**

Selon une option représentée à la figure 3, il peut être prévu deux pompes 1,11 en parallèle l'une de l'autre. Ainsi une avarie sur l'une des pompes n'a qu'un impact limité, et le fonctionnement général n'est que peu affecté. On peut ainsi drastiquement réduire le taux d'indisponibilité d'un tel système de transfert thermique.

Selon une configuration alternative illustrée à la figure 9, la pompe est alimentée par du liquide prélevé en aval de l'échangeur refroidisseur **5** (point de prélèvement **15),** et rejette du liquide en amont de l'échangeur refroidisseur (point de rejet **16).** Dans une autre configuration possible, la pompe est alimentée par du liquide prélevé en amont de l'échangeur refroidisseur **5** (point de prélèvement **15),** et rejette du liquide en aval de l'échangeur refroidisseur (point de rejet **16).**

Selon encore une autre configuration alternative illustrée à la figure 10, la pompe est alimentée par du liquide prélevé en un point intermédiaire **15** entre l'échangeur refroidisseur et le boîtier intermédiaire, et rejette du liquide en amont dudit point intermédiaire au point repéré **16.**

Dans l'exemple illustré aux figures 9 et 11, le (ou les) évaporateur(s) est (sont) positionné(s) en contrebas du circuit principal. Dans ce cas, la canalisation de l'admission de l'évaporateur est descendante, et s'il se trouve des bulles **29** de vapeur ou de gaz non condensable à cet endroit, elles vont être évacuées en remontant naturellement et en rejoignant le circuit principal et le réservoir vase d'expansion.

## Revendications

1. Système de transfert thermique (100) comprenant :
- un circuit principal (10) en boucle fermée, comprenant une quantité prédéfinie de fluide réfrigérant, avec une direction de circulation (F) de boucle de fluide,
- au moins un échangeur refroidisseur (5), comprenant une portion du circuit principal et un échangeur de chaleur couplé à une source froide, pour évacuer des calories et sous refroidir du liquide, pour délivrer du liquide sous-refroidi,
- au moins une pompe (1) agencée sur une branche parallèle (14) au circuit principal, pour impartir une circulation de liquide dans le circuit principal selon la direction de circulation de boucle (F), avec prélèvement et rejet à des endroits respectifs où le réfrigérant est en phase liquide,
- au moins un boitier intermédiaire (3) placé en série sur le circuit principal, présentant au moins 3 ports, à savoir une entrée de liquide (31), une sortie de liquide (32), et une entrée vapeur (33), l'entrée de liquide recevant le liquide sous-refroidi en provenance de l'échangeur refroidisseur,
- au moins un ensemble évaporateur (2) agencé en dérivation du circuit principal avec
- au moins une canalisation d'admission (21), prélevant du fluide liquide sur le circuit principal,
- un évaporateur (20) incluant un élément poreux (22) à pompage capillaire couplé à une source chaude à refroidir, pour être le siège d'une vaporisation du fluide réfrigérant,
- au moins une canalisation de sortie (25) ayant au moins une buse d'éjection (26) qui injecte le fluide en phase principalement vapeur dans le boitier intermédiaire (3) via l'entrée vapeur (33) selon la direction de circulation de boucle (F).

2. Système de transfert thermique selon la revendication 1, dans lequel la pompe est alimentée par du liquide sous-refroidi en provenance de l'échangeur refroidisseur et rejette plus en aval un jet de liquide dans le circuit principal, en amont du boitier intermédiaire (3).

3. Système selon l'une des revendications 1 à 2, dans lequel le boitier intermédiaire (3) comprend un volume intérieur disponible pour loger un excédent de liquide, faisant fonction de réservoir et de vase d'expansion.

4. Système selon l'une des revendications 1 à 3, dans lequel le boitier intermédiaire (3) présente une forme allongée avec un axe (A3) selon la direction locale de circulation de boucle.

5. Système selon la revendication 4, dans lequel le boitier intermédiaire présente une forme généralement cylindrique.

6. Système selon l'une des revendications 4 à 5, dans lequel le boitier intermédiaire comprend un tube de guidage (6) qui entoure la buse d'éjection (26).

7. Système selon l'une des revendications 1 à 6, dans lequel le boitier intermédiaire (3) comprend une deuxième sortie liquide (34) raccordée à la canalisation d'admission (21) de l'ensemble évaporateur (2).

8. Système selon l'une des revendications 1 à 7, dans lequel il est prévu dans le circuit principal une restriction de section (9) juste en aval du rejet de la pompe.

9. Système selon l'une des revendications 1 à 8, dans lequel la pompe est une pompe centrifuge présentant un poids inférieur à 1 kg et un volume inscrit dans un cube de 100 mm de côté.

10. Système selon l'une des revendications 1 à 9, dans lequel le fluide de travail est de l'acétone.
